Europäisches Patentamt

European Patent Office

Office européen des brevets

(19)

(11) Publication number:

**0 365 199**
**A2**

## (12) EUROPEAN PATENT APPLICATION

(21) Application number: **89310358.0**

(22) Date of filing: **10.10.89**

(51) Int. Cl.5: **H01L 21/205 , C30B 29/40**

(30) Priority: **19.10.88 US 259656**

(43) Date of publication of application:
**25.04.90 Bulletin 90/17**

(84) Designated Contracting States:
**DE ES GB NL**

(71) Applicant: **AMERICAN TELEPHONE AND
TELEGRAPH COMPANY
550 Madison Avenue
New York, NY 10022(US)**

(72) Inventor: **Buckley, Denis Noel
156 Westervelt Avenue
N. Plainfield New Jersey 07060(US)**
Inventor: **Johnston, Wilbur Dexter, Jr.
30 Oak Knoll Road
Mendham New Jersey 07945(US)**

(74) Representative: **Johnston, Kenneth Graham et
al
AT&T (UK) LTD. AT&T Intellectual Property
Division 5 Mornington Road
Woodford Green Essex, IG8 OTU(GB)**

(54) Vapor phase growth process using organo-group V compounds.

(57) A vapor phase growth process is disclosed for the fabrication of III-V devices which utilizes organo-Group V compounds as a source material. In particular, organoarsenic and/or organophosphorus compounds are used and provide epitaxial layers of morphology similar to those grown with conventional hydride sources. Preferred organo-Group V compounds are liquids at room temperature and are considerably less toxic than their hydride (gaseous) counterparts. The organo-Group V sources may be used not only as a source during epitaxial growth, but as a wafer ambient which is used to prevent surface decomposition both before and after epitaxial growth.

EP 0 365 199 A2

## VAPOR PHASE GROWTH PROCESS USING ORGANO-GROUP V COMPOUNDS

Background of the Invention

1. Field of the Invention

The present invention relates to a vapor phase growth process for depositing films of III-V materials on a semiconductor substrate and, more particularly, to such a process which utilizes organo-Group V compounds.

2. Description of the Prior Art

Devices such as lasers, light emitting diodes (LEDs), and FETs are often formed of Group III-V semiconductor materials. These devices may be grown by liquid-phase epitaxy (LPE), metalorganic chemical vapor deposition (MOCVD), molecular-beam epitaxy (MBE), or vapor phase epitaxy (VPE) processes. The LPE process is relatively simple and inexpensive. However, there exist problems in the LPE method related to growth uniformity, melt carry-over and terrace formation. The drawbacks associated with MOCVD include the formation of compounds during side reactions between the phosphine and the indium alkyls, and the possibility of carbon contamination from the organic compounds present in the system. MBE is a very expensive and complex process, and may present problems in mass production-scale systems. In light of the above, VPE is often the growth process of choice, exhibiting good thickness and compositional uniformity, flexible control of alloy composition, and compatibility with manufacturing. A complete description of a typical hydride VPE process may be found in the reference GaInAsP Alloy Semiconductors, edited by T. P. Pearsall, John Wiley & Sons (1982), at Chapter II, Section 1 entitled "Vapor-phase Epitaxy of GaInAsP" by G. H. Olsen, at pp. 11-41.

An alternative hydride VPE process is disclosed in U.S. Patent No. 4,729,968 issued to R. F. Karlicek, Jr. on March 8, 1988. The Karlicek system incorporates a procedure to insure that the phosphine utilized in the process is completely decomposed before reaching the deposition area. In particular, a catalyst, such tungsten, is reacted with phosphine in the source region of the reactor to accelerate the decomposition of the phosphine, where a lack of complete phosphine decomposition has been found to increase the presence of hillocks on the surface of the grown layer.

A problem with these and other VPE growth processes is that arsine (AsH$_3$) and phosphine (PH$_3$), commonly used as sources of the Group V material, are both extremely toxic gases. Arsine is reported to have an LC$_{50}$ (lethal concentration for 50% of a test population) for rats of 45 ppm for a four hour exposure. The American Conference of Governmental Industrial Hygienists (ACGIH) has recommended a threshold limit value (TLV) of 0.05 ppm of the gas in air. Phosphine is known as a potent central nervous system poison which is reported to have an LC$_{50}$ for rats of 11 ppm for a four hour exposure. A threshold limit value (TLV) of 0.2 ppm for phosphine has been set by the ACGIH. The use of such sources in VPE processes thus raises serious safety concerns for the industry. Such concerns will become even greater as the use of VPE systems to form III-V semiconductor devices proliferates to meet the increasing industry demand for these components. The possibility also exists of governmental regulation regarding the use of arsine and phosphine - in the form of restricting the volume of gas which may be employed, increasing safety requirements, or banning altogether the use of these toxic gases.

In light of the toxicity problems discussed above, there is a need to find alternative, less toxic, sources for the Group V components of III-V semiconductor devices for use with the VPE growth process.

Summary of the Invention

The problem remaining in the prior art has been solved by the present invention which relates to a vapor phase growth process for depositing films of III-V material and, more particularly, to such a process which utilizes organo-Group V sources.

In accordance with the present invention, organoarsenic and organophosphorus compounds are used in place of arsine and phosphine, respectively. Many of these compounds are liquids at room temperature and are generally much less toxic than their hydride counterparts. During the decomposition process, the organo-Group V compound is pyrolyzed and forms the elemental product vapor and various byproducts (mainly hydrocarbons). The method has not been found to cause any carbon incorporation into the growing epitaxial layer.

Brief Description of the Drawing

Referring now to the drawings:

FIG. 1 illustrates an exemplary VPE growth reactor including the organo-Group V sources of the present invention;

FIG. 2 illustrates the background carrier concentration profiles of InGaAs layers grown on InP substrates using, in turn, the conventional hydride system (arsine gaseous source) and an exemplary organoarsenic source of the present invention (trimethylarsenic liquid source); and

FIG. 3 illustrates the concentration profiles of InP epitaxial layers grown on InP substrates using, in turn, the conventional hydride system (phosphine gaseous source) and an exemplary organophosphorus source of the present invention (trimethylphosphorus liquid source).

## Detailed Description

The VPE growth system as described below offers two major advantages over the MOCVD (OMVPE) systems mentioned above with respect to the utilization of organo-Group V replacement sources. First, the source region of a VPE reactor, as described in detail below, acts as a high temperature "precracker" to fully dissociate the Group V material before it enters the growth region of the reactor (a temperature of approximately 790°C is used in the source region of the reactor). Therefore, very little (if any) of the organo-Group V compound will enter the growth region, where it is assumed that the presence of such compounds is responsible for the carbon incorporation problems mentioned above. Secondly, no other organic sources are involved in the VPE growth process, where the presence of organics in the other systems mentioned above may also lead to the carbon incorporation problem.

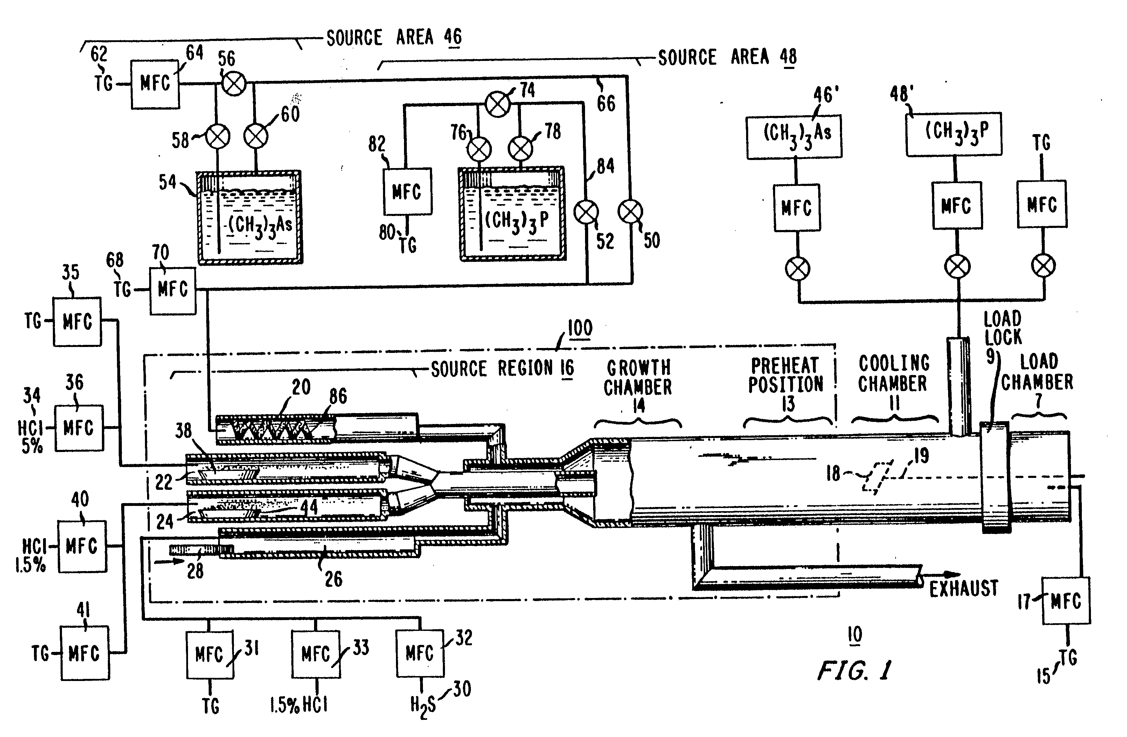

An exemplary VPE system 10 which may be used with the process of the present invention is illustrated in FIG. 1. It is to be understood that various other VPE reactor arrangements may be used in association with the III-V growth process of the present invention. Additionally, reactor 10, as illustrated in FIG.1, includes sources of both an organoarsenic compound and an organophosphorus compound. Other arrangements may require the utilization of only one such organo-Group V source. These arrangements are also considered to be within the scope of the present invention.

Referring to FIG. 1, reactor 10 includes a cooling chamber 11, a preheat chamber 13, a growth chamber 14, and a source region 16, each consisting of quartz tubing. The growth process basically involves inserting a wafer 18 into preheat chamber 13, initiating the flow of the desired Group III and Group V materials through source region 16 and into growth chamber 14, then translating wafer 18 into growth chamber 14 for exposure to the gaseous flow of the Group III-V materials. The process will be described below in more detail with respect to Examples 1 and 2. Source chamber 16 of reactor 10 includes four separate input tubes 20,22,24 and 26 for the introduction of various materials. In this particular embodiment, the Group V material (organoarsenic and/or organophosphorus compounds) are introduced through input tube 20, the indium Group III material through input tube 22, and the gallium Group III material through input tube 24. Input tube 26 is reserved for the introduction of HCl and various dopants. The dopants may be a zinc pellet 28 (for introducing a p-type conductivity), or a gaseous hydrogen sulfide 30 (for n-type). As shown in FIG. 1, the introduction of hydrogen sulfide 30 is regulated by a mass flow controller 32. With respect to the introduction of the indium, a gaseous source 34 of HCl, as controlled by a mass flow controller 36, is transferred into input tube 22 and passed over a molten source of indium loaded in a boat 38. The HCl then transports the indium in its monochloride form (InCl) from source region 16 to growth chamber 14. Another gaseous source 40 of HCl, as regulated by a mass flow controller 42, is used to transport the gallium source material, loaded in a boat 44, in its monochloride form (GaCl) through input tube 24 and into growth region 14.

The organo-Group V constituent, in accordance with the teachings of the present invention, is introduced into source region 16 through input tubing 20. In particular, tubing 20 branches into two separate source areas 46 and 48, as controlled by a set of valves 50,52. Source area 46 is associated with providing the organoarsenic compound when valve 50 is open. Source area 48 is associated with providing the organophosphorus compound when valve 52 is open. Additionally, if it is desired to grow a quaternary layer of InGaAsP, both valves 50 and 52 will be opened. It is to be noted that if only one source is required, valves 50,52 may be eliminated and tubing 20 directly connected to the desired organo-Group V source. Additionally, the following discussion will focus on trimethylarsenic as the organoarsenic source of choice. However, it is to be understood that other organoarsenic compounds, including but not limited to, diethylarsine, triethylarsenic, isobutylarsine, and tertiarybutylarsine may also be used.

As discussed above, trimethylarsenic is a liquid at room temperature, and as such may be contained in, for example, a bubbler 54 maintained at a constant temperature of, for example, 0°C. In order to provide the trimethylarsenic to source region 16, a valve 56 is closed, and valves 50,58,60 are opened, allowing a transport gas (TG) source 62 (hydrogen or helium are commonly used as transport gasses), as controlled by a mass flow controller 64, to enter the liquid and bubble through the trimethylarsenic. The gas which then escapes bubbler 54 is trapped in tubing 66 and transported towards source region 16. Another transport gas source 68, regulated by a mass flow controller 70, may be located downstream from trimethylarsenic source 46 to further dilute the trimethylarsenic traveling along tubing 66. Such dilution is not required but has been found to increase the transport speed and remove any fluctuations in the presentation of trimethylarsenic into tubing 66, where such fluctuations may occur if the bubbling rate is rather slow and poorly controlled.

It is to be noted that there exists a variety of other techniques which may be utilized to transport the organo-Group V constituent into source region 16. For example, in low-pressure hydride VPE systems, the transport will occur without the assistance of such an inert transport gas. Alternatively, a liquid organo-Group V source may be directly injected into source region 16. Diffusion techniques may also be used. In general, any suitable technique may be used to introduce the organo-Group V constituent into source region 16 and fall within the scope of the teaching of the present invention.

In accordance with the VPE growth technique, source region 16 is maintained at an elevated temperature of, for example, 790°C, where this temperature is required to provide the thermal decomposition (pyrolysis) of the trimethylarsenic, as well as for the forming of InCl and GaCl in inlet tubes 22 and 24, respectively. The trimethylarsenic introduced into heated source region 16 is then pyrolyzed in a process such as:

$$4(CH_3)_3As + 6H_2 \longrightarrow As_4 + 12CH_4,$$

where it has been found that the methane by-product does not result in the incorporation of any unwanted carbon into the layer being grown on the wafer surface.

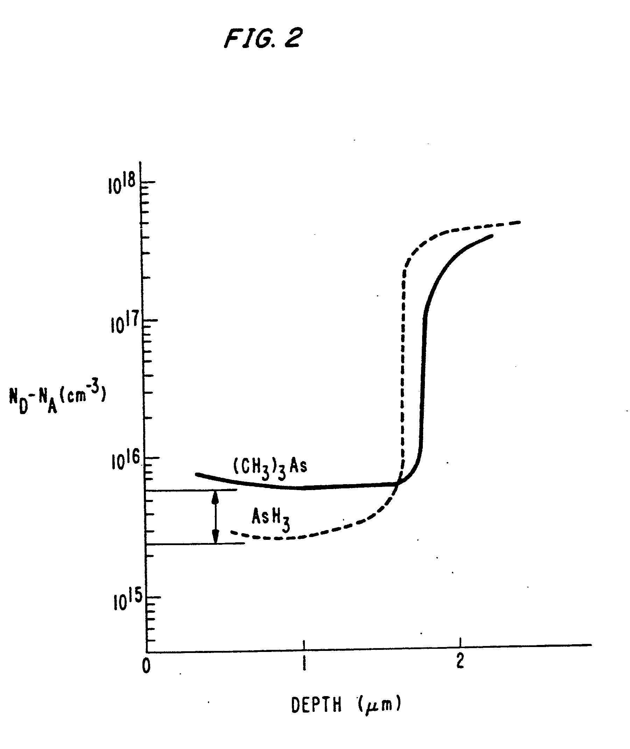

It has been found that the quality of As-containing layers grown with trimethylarsenic are essentially identical to those grown with the conventional toxic arsine source. For example, identical hydrogen flow rates may be used to grow layers of similar morphology. FIG. 2 illustrates a comparison of the background (n-type) carrier concentrations for both an InGaAs epitaxial layer grown with the conventional arsine source and an InGaAs layer grown with trimethylarsenic, as a function of depth into the grown layer. As seen, the profiles for these two layers follow the same basic curve, the difference being a higher carrier concentration (by a factor of 2 or 3) for the grown layer in the case of the trimethylarsenic curve. This increase in background carrier concentration is attributed to the relatively high levels of donor impurities which are often found in liquid arsenic alkyl sources, as compared with the gaseous arsine source. This level, however, is considered to be sufficiently low for the growth of most laser, LED and FET structures. Further work on purifying the arsenic alkyl source material will be required if it is desired to reduce this carrier concentration to the level associated with the conventional arsine process.

Referring back to FIG. 1, an organophosphorus compound may be transported into source chamber 16 using any of the processes described above. It is to be noted that various organophosphorus compounds, including but not limited to trimethylphosphorus, isobutylphosphine, tertiarybutylphosphine, triethylphosphorus, and diethylphosphine are equally functional for epitaxial growth in accordance with the teachings of the present invention. The following discussion will focus, however, on trimethylphosphorus as one such exemplary source.

As shown in FIG. 1, an exemplary phosphorus source area 48 may include a bubbler 72 which contains the liquid trimethylphosphorus at a predetermined temperature (0°C, for example). As discussed above, various other transport techniques may be used. For the introduction of trimethylphosphorus into source region 16, valve 74 is closed, and valves 52,76 and 78 are opened. A transport gas source 80, under the control of a mass flow controller 82, passes through the tubing and enters bubbler 72. The gaseous bubbles escaping the surface of the liquid contain trimethylphosphorus vapor then enter tubing 84 and are transported towards source region 16 through input tubing 20. As with the trimethylarsenic process described above, the gaseous trimethylphosphorus may be further diluted by the upstream transport gas source 68 to increase its transport speed and lower its fluctuation. As will be described in detail below in association with Example 2, the total flow rates into input tube 20 associated with trimethylphosphorus must be reduced from the 500-750 sccm (standard cm. cubed min$^{-1}$) of a conventional phosphine-based VPE process to achieve good epitaxial growth. It has been discovered, however, that the addition of a catalyst, such as tungsten, allows the flow rate to be returned to its conventional level. The use of such a catalyst in a hydride VPE process is disclosed and described in detail in Karlicek, *supra*. Referring back to FIG. 1, a tungsten coil 86 included as shown in tubing 20 is sufficient for this purpose. Similar to the trimethylarsenic reaction, the pyrolysis of trimethylphosphorus within heated (790°C) source region 16 occurs by a process such as:

$$4(CH_3)_3P + 6H_2 \longrightarrow P_4 + 12CH_4.$$

As with the trimethylarsenic process discussed above, the pyrolysis of trimethylphosphorus creates methane as a by-product, which is not considered to affect the quality of the P-containing layer being grown.

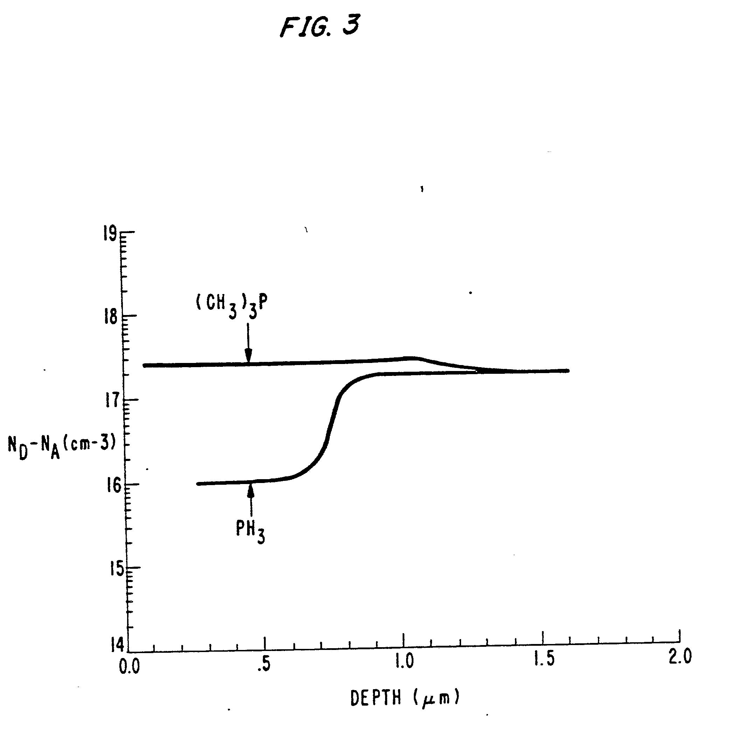

A comparison of the background carrier concentration profiles of InP epitaxial layers grown with the conventional phosphine source and trimethylphosphorus are illustrated in FIG. 3. It is to be noted that a tungsten catalyst was utilized in growing the trimethylphosphorus layer analyzed to create the profile of FIG. 3. As seen, there is a significant increase in carrier concentration (of approximately a factor of sixty) when trimethylphosphorus is used as the source material. It has been demonstrated by Secondary Ion Mass Spectrometry (SIMS) measurements on the InP layers that this is primarily due to the presence of silicon impurities in the liquid phosphorus alkyl source. Further work on the purification of the organophosphorus source may be required to reduce this background carrier concentration.

In conventional VPE processes, the wafers are present in preheat chamber 13 of reactor 10 during both the ramp-up to growth temperature (700°C) and in cooling chamber 11 during the cool-down following the growth of the epitaxial layer. During both time periods, phosphine (or arsine, where appropriate) is often introduced into preheat chamber 13 and cooling chamber 11 to prevent decomposition on the wafer surface. In accordance with the teachings of the present invention, the various organo-Group V compounds discussed above may also be used to perform this function. FIG. 1 illustrates additional organoarsenic and organophosphorus source areas 46' and 48', respectively, which may be used for this purpose.

## Example 1

Indium phosphide substrates were cut so that their major surface was in the <100> plane, the substrates being either sulfur-doped or iron-doped (semi-insulating) material. These substrates were chemically polished to a thickness of approximately 10 mil. After polishing, the substrates were cleaved to the sample size of approximately 19mm x 19mm. The samples were then stored under dry nitrogen until use.

Immediately before growth, the samples were cleaned by sequential immersion for 15 minutes in boiling trichloroethane, 2 minutes in acetone, and 2 minutes in methanol. The samples were then etched in a room temperature 5:1:1 mixture of sulfuric acid, hydrogen peroxide and water, followed by an etch in 10% hydrofluoric acid for 2 minutes. Substrates 18 were placed on a quartz sample holder 19 (FIG. 1) in load chamber 7 of reactor 10. Load chamber 7 was evacuated to 10 Torr and then backfilled with hydrogen from a source 15 controlled by a mass flow controller 17 to a pressure of approximately 780 Torr. Reactor 10 was initially maintained with a furnace 100 at a temperature of 790°C in source region 16 and 700°C in both growth chamber 14 and preheat chamber 13. At these temperatures, a continuous flow of hydrogen at 2 liters/min was maintained by introducing equal hydrogen flows through each of the input tubes 20,22,24 and 26, by means of mass flow controllers 70,35,41, and 31, respectively. Hydrogen being the transport gas of choice for this example.

A flow of trimethylphosphorus vapor in hydrogen (or phosphine in hydrogen) was passed through preheat chamber 13 to preserve substrate 18. Substrate 18 was then introduced into preheat chamber 13 via load-lock 9. The flow of hydrogen through mass flow controller 70 and into input tube 20 was adjusted to 495 sccm and a flow of hydrogen of 5 sccm was passed, by means of mass flow controller 64, through bubbler 54 by closing valve 56 and opening valves 58 and 60, thus transporting trimethylarsenic vapor into input tube 20 of reactor 10.

The hydrogen flow through mass flow controller 35 was adjusted to 350 sccm and a flow of 150 sccm of 5% hydrogen chloride in hydrogen was passed, by means of mass flow controller 36, over indium metal source boat 38. The hydrogen flow through mass flow controller 41 was adjusted to 460 sccm and 40 sccm of 1.5% hydrogen chloride in hydrogen was passed, by means of mass flow controller 40, over gallium source boat 44. The hydrogen flow through mass flow controller 31 was adjusted to 488 sccm and a flow of 12 sccm of 1.5% hydrogen chloride in hydrogen was passed through mass flow controller 33 and directed into input tube 26.

Five minutes after the introduction into preheat chamber 13, substrate 18 was translated into growth chamber 14 of reactor 10. This translation initiated the growth of an indium gallium arsenide (InGaAs) layer on the indium phosphide (InP) substrate 18. The trimethylphosphorus/hydrogen (or phosphine/hydrogen) flow through cooling chamber 11 and preheat chamber 13 was replaced by a trimethylarsenic/hydrogen (or arsine/hydrogen) flow. Approximately thirty minutes after it was transferred into growth chamber 14, substrate 18 was translated into cooling chamber 11. Substrate 18 was removed three minutes later through load-lock 9 into load chamber 7. Substrate 18 was then removed from reactor 10.

The indium gallium arsenide layer was examined visually and by means of Nomarski phase contrast microscopy, scanning electron microscopy, x-ray diffraction, capacitance voltage measurements and/or Hall effect measurements. The layer was found to have properties similar to samples grown using arsine, except for the background carrier concentration, which was approximately three times greater than that of conventional layers.

### Example 2

Indium phosphide substrates were cut so that their major surface was in the <100> plane, the substrates being either sulfur-doped or iron-doped (semi-insulating) material. These substrates were chemically polished to a thickness of approximately 10 mil. After polishing, the substrates were cleaved to the sample size of approximately 19mm x 19mm. The samples were then stored under dry nitrogen until use.

Immediately before growth, the samples were cleaned by sequential immersion for 15 minutes in boiling trichloroethane, 2 minutes in acetone, and 2 minutes in methanol. The samples were then etched in a room temperature 5:1:1 mixture of sulfuric acid, hydrogen peroxide and water, followed by an etch in 10% hydrochloric acid for 2 minutes. Substrates 18 were placed on a quartz sample holder 19 (see FIG. 1) in load chamber 7 of reactor 10. Load chamber 7 was evacuated to 10 Torr and then backfilled with hydrogen from a source 15 controlled by mass flow controller 17 to a pressure of approximately 780 Torr. Reactor 10 was initially maintained with a furnace 100 at a temperature of 790°C in source region 16 and 700°C in both growth chamber 14 and preheat chamber 13. At these temperatures, a continuous flow of hydrogen at 2 liters/min. was maintained by introducing equal hydrogen flows through each of the input tubes 20,22,24 and 26, by means of mass flow controllers 70,35,41 and 31, respectively.

A flow of trimethylphosphorus vapor in hydrogen (or phosphine in hydrogen) was passed through preheat chamber 13 for wafer preservation of substrate 18. Substrate 18 was then introduced to preheat chamber 13 via load-lock 9. The flow of hydrogen through mass flow controller 70 into input tube 20 was adjusted to 490 sccm and a flow of hydrogen of 10 sccm was passed, by means of mass flow controller 82, through bubbler 72 by closing valve 74 and opening valves 76 and 78, thus transporting trimethylphosphorus vapor which mixed with the 400 sccm flow of hydrogen. The combined flow then passed into input tube 20 of reactor 10 and passed over tungsten catalyst 86. As with Example 1, hydrogen is the transport gas of choice for this discussion.

As discussed above, it was found that these flow conditions provided satisfactory indium phosphide growth, as long as a tungsten catalyst was present. Satisfactory growth of indium phosphide could be obtained in the absence of such a catalyst if the total gas flow through input tube 20 was reduced to 100 sccm, by reducing the hydrogen flow through mass flow controller 70 to 90 sccm.

The hydrogen flow through mass flow controller 35 was adjusted to 200 sccm and a flow of 300 sccm 5% hydrogen chloride in hydrogen was passed, by means of mass flow controller 36, over indium metal source boat 38. The hydrogen flow through mass flow controller 31 was adjusted to 488 sccm and 12 sccm of 1.5% hydrogen chloride in hydrogen was passed through mass flow controller 33 and into input tube 26. Five minutes after it had been introduced into preheat chamber 13, substrate 18 was translated into growth chamber 14. This translation initiated the growth of an indium phosphide (InP) layer on substrate 18. This growth was continued for a time period of approximately 30 minutes.

Subsequent to the growth, substrate 18 was translated into cooling chamber 11. Three minutes later, substrate 18 was removed through load-lock 9 into load chamber 7. Substrate 18 was then removed from reactor 10.

The indium phosphide layer was examined visually and by means of Nomarski phase contract microscopy, x-ray diffraction, capacitance voltage measurements and secondary ion mass spectrometry (SIMS). It was found to have properties similar to samples grown using phosphine, except for the background carrier concentration which was approximately 60 times higher than conventionally grown samples. As discussed above, this higher value is primarily due to silicon impurities found in the liquid trimethylphosphorus source.

### Claims

1. A method of forming a device using a vapor phase process for growing a Group V-containing epitaxial layer, the method comprising the steps of:
a) providing a wafer of appropriate substrate material (e.g.18);
b) exposing the wafer to a Group-V containing vapor (e.g. 20); and
c) inducing deposition of said Group V-containing vapor on said wafer
CHARACTERIZED IN THAT
in performing step b), an organo-Group V source is used.

2. The method of claim 1 wherein the organo-Group V source is chosen from the group consisting of organoarsenic and organophosphorus compounds.

3. The method of claim 2 wherein the organoarsenic compound is chosen from the group consisting of diethyl-arsine, triethylarsenic, trimethylarsenic, isobutylarsine and tertiarybutylarsine.

4. The method of claim 3 wherein the chosen organoarsenic compound is trimethylarsenic.

5. The method of claim 2 wherein the organophosphorus compound is chosen from the group consisting of isobutylphosphine, tertiarybutylphosphine, triethylphosphorus, trimethylphosphorus, and diethylphosphine.

6. The method of claim 5 wherein the chosen organophosphorus compound is trimethylphosphorus.

7. A method of forming a device using a vapor phase process for growing an epitaxial layer including Group V material, the method comprising the steps of:

a) providing a wafer of appropriate substrate material (e.g., 18);

b) introducing the wafer into the preheat chamber of a vapor phase reactor (e.g., 13);

c) exposing said wafer to Group V source for prevention of surface decomposition;

d) heating the growth chamber to the appropriate growth temperature;

e) translating said wafer from the preheat chamber to the growth chamber (e.g., 14);

f) exposing the wafer to the vaporous Group V source at the appropriate growth temperature;

g) inducing deposition of the Group V material onto said wafer through interaction with said vapor; and

h) translating said wafer from the growth chamber to a cool-down chamber (e.g., 11);

i) cooling said wafer subsequent to the deposition performed in step g); and

j) exposing the wafer to a vaporous Group V source during step i) to prevent surface decomposition.
CHARACTERIZED IN THAT
in performing steps c), f) and j), an organo-Group V source is used.

8. The method of claim 7 wherein in performing steps c) and j) the surface decomposition prevention organo-Group V source is chosen from the group consisting of organoarsenic and organophosphorus compounds.

9. The method of claim 8 wherein the surface decomposition prevention organoarsenic compound is trimethylarsenic.

10. The method of claim 8 wherein the surface decomposition prevention organophosphorus compound is trimethylphosphorus.

11. The method of claim 7 wherein in performing step f), the organo-Group V source is chosen from the group consisting of organoarsenic and organophosphorus compounds.

12. The method of claim 11 wherein the organoarsenic compound is chosen from the group consisting of diethyl-arsenic, triethylarsenic, trimethylarsenic, isobutylarsine and tertiarybutylarsine.

13. The method of claim 12 wherein the chosen organoarsenic compound is trimethylarsenic.

14. The method of claim 11 wherein the organophosphorus compound is chosen from the group consisting of isobutylphosphine, tertiarybutylphosphine, triethylphosphorus, trimethylphosphorus, and diethylphosphine.

15. The method of claim 14 wherein the chosen organophosphorus compound is trimethylphosphorus.

FIG. 1

EP 0 365 199 A2

# FIG. 2

## FIG. 3